# EUROPEAN PATENT APPLICATION

(11) **EP 4 567 888 A1**
(43) Date of publication of application: **11.06.2025**
(21) Application number: 23213995.6
(22) Date of filing: 04.12.2023
(51) Int. Cl.: H01L 25/075, H01L 33/62, H01L 33/48

(54) **DUAL COLOR LED ASSEMBLY**

(71) Applicant: Lumileds LLC, San Jose, CA 95131 (US)
(72) Inventor: Henninger, Georg, San Jose, 95131 (US); Kleijnen, Christian, San Jose, 95131 (US)
(74) Representative: dompatent von Kreisler Selting Werner - Partnerschaft von Patent- und Rechtsanwälten mbB

(57) **Abstract**

Dual Color LED assembly comprising: a printed circuit board, substrate, having an upper side and an opposite lower side; two LEDs arranged on the upper side of the substrate, wherein the LEDs are configured to emit light with different colors; wherein the two LEDs are electrically connectable antiparallel on the substrate.

## Description

The present invention relates to a dual Color LED assembly in particular used in a dual color LED lighting device.

In the prior art LED light sources with a plurality of groups of individually addressable LEDs are known. Therein, an interposer or PCB is connected to other interposers by flexible conductors in order to shape the light source as desired. Therein, on each interposer a single LED is disposed as light emitting element. In order to increase the number of possible groups that can be addressed, i. e. increase the resolution of the lighting source without increase of implemented interposer, it is suggested to use the voltage direction to address LEDs which are connected antiparallel. Hence, for a first voltage direction, a first LED is activated, wherein for the opposite voltage direction a second LED is activated. This is referred to as antiparallel drive mode. Therein, both LEDs may be placed on the same interposer. In the prior art the interposer comprises contact pads, wherein anode and cathode pads of the two LEDs are arranged next to each other when viewed from the backside. Hence, in order to achieve an antiparallel connection of the two LEDs on the one interposer, the conductors between the interposes or conductor lines within the interposer need to be crossed which leads to a complex routing and higher complexity of the overall structure. Hence, it is an object of the present invention to provide a dual color LED assembly which can be simply implemented in an antiparallel drive mode.

The problem is solved by a dual color LED assembly according to claim 1 as well as a lighting device according to claim 17.

The dual color LED assembly, according to the present invention, comprises a substrate which is also known and denoted as interposer, having an upper side and an opposite lower side. Two LEDs are arranged on the upper side of the substrate to emit their light in the same direction, wherein the two LEDs are configured to emit light with different colors. Therein, according to the present invention, the LEDs are electrically connectable in an antiparallel configuration. This means that when one LED is powered the other LED is reversely biased to block the electrical current going through it. In consequence, at no point in time the two LEDs can be jointly powered in a way that both LEDs generate light simultaneously. Due to phosphor afterglow, this may be different for the light emitted from the LEDs, at least for short time periods. Therein, the LEDs may be spatially arranged on the substrate in a parallel configuration. Alternatively, the two LEDs are arranged antiparallel on the substrate. Thus, by the parallel or antiparallel arrangement of the LEDs on the substrate, connection of the LEDs in an antiparallel drive mode is simplified. No crossing conductors in the substrate or in the external conductors connecting the two LEDs are necessary. Complex routing of the conductors can be avoided.

Preferably, the anode of the first LED is directly next to the cathode of the second LED and the cathode of the first LED is directly next to the anode of the second LED. Of course, due to the structure of the LEDs itself, the anode and cathode of the first LED are arranged directly next to each other, and the anode and cathode of the second LED are arranged directly next to each other. Consequently, the anode of the first LED and the cathode of the second LED as well as the cathode of the first LED and the anode of the second LED can be easily connected since they are arranged directly next to each other. No crossing of connectors or conducting wires is necessary. Therein, the die of the LEDs is arranged in the plane corresponding to the upper plane or the lower plane, i.e. the layers of the die defining the cathode and the anode of the LED are arranged in a plane perpendicular to the direction of light emission.

Preferably, the substrate is a ceramic substrate, in particular made from AIN (aluminum nitride) or Al₂O₃ (aluminum oxide). Alternatively, the substrate is a rigid or flexible printed circuit board (PCB).

Preferably, the substrate is a lead frame. In the case of a lead frame, the LEDs and in particular their dies are arranged by lateral layers of the die arranged in the direction of light emission, i.e. along a direction perpendicular to the upper surface and/or the lower surface. The lateral layers define the anode and the cathode of the LEDs. Therein, the layers of the two LEDs may be arranged in the same order, i.e. arranged in parallel, or may be arranged in opposite order, i.e. anti-parallel.

The LEDs may generate blue light that is converted to another color by Phosphors. The Phosphors may be applied embedded in a ceramic platelet that is attached to the blue light emitting LEDs. Preferably these LEDs are attached to a ceramic substrate in the dual color emitting LED assembly.

The Phosphors may also be contained in a Silicone matrix that is enclosing the blue light emitting LEDs. Preferably these LEDs area attached to a lead frame in the dual color emitting LED assembly, whereby the LEDs are separated by a dam made of Silicone Moulding Compound (SMC) or Epoxy Moulding Compound (EMC), to prevent unwanted color mixing.

The LEDs may also directly generate and emit one of the two colors. Preferably these LEDs are attached to a lead frame in the dual color emitting LED assembly. In case both LEDs directly emit the two colors, the LEDs are preferably embedded together in a transparent Silicone to emit light from the same light emitting surface.

Preferably, the lead frame is split into four planes, arranged in a rectangle, separated by gaps in the lead frame, wherein lateral LEDs with identical electrical build-up are directly connected electrically, for example by gluing with a conductive glue, soldering or the like, to diagonally opposite planes of the lead frame. Further, each LED is connected to one of the remaining quarter planes by a respective wire bond. In this case, the lateral layers of the two LEDs may be arranged in parallel, wherein crossing of any conductors is prevented by arranging the LEDs on diagonally opposite planes of the lead frame. In this case, the lateral structure of the LEDs may be arranged in parallel.

Alternatively, lateral LEDs with opposite electrical build-up are directly connected electrically, for example by gluing with a conductive glue, soldering or the like, to directly neighboring planes of the four planes of lead frame. Further, each LED is connected to one of the remaining neighboring planes by a respective wire bond. In this case, the lateral layers of the two LEDs may be arranged anti-parallel in order to avoid crossing conductors. In this case, the lateral structure of the LED may be arranged anti-parallel.

Alternatively, LEDs with two electrical top contacts are thermally conductively attached to neighbouring or diagonally opposite planes of the lead frame, wherein each LED is electrically connected to said neighbouring or diagonally opposite plane by a wire bond and to one of the remaining planes with another wire bond. Thus, each plane of the lead frame is electrically contacted to one LED by one of the wire bonds. In this case, the lateral structure of the LEDs may be arranged in parallel. Preferably the LEDs are nevertheless connected electrically conductively to the lead frame by an electrically conductive glue or soldering, to ease thermal conductance of the heat generated by the LED to the lead frame.

Preferably, the lead frame is separated into a first lead frame plane and a second lead frame plane separated by a gap in the lead frame, whereby one LED is placed on the first lead frame plane and the second LED is placed on the second lead frame plane, wherein the LEDs are directly electrically connected to the respective lead frame plane and electrically connected to the other lead frame plane by a wire bond each. Therein, the LED on the first lead frame plane is connected to the second lead frame plane by a wire bond. Similar, the LED on the second lead frame plane is connected to the first lead frame plane by a wire bond. Further, the LED on the first lead frame plane may be electrically connected to the first lead frame plane by a wire bond or may be electrically connected by an electrically conductive glue or soldering to the first lead frame plane. Similar, the LED on the second lead frame plane may be electrically connected to the second lead frame plane by a wire bond or may be connected by an electrically conductive glue or soldering to the second lead frame plane. Therein, the lateral layers of the LEDs may be arranged in parallel. Thus, crossing of the conductors may be prevented by the specific arrangement of the LEDs on the lead frame. Preferably, the lead frame is separated into a first lead frame plane and a second lead frame plane separated by a gap in the lead frame, whereby the first LED is placed on the first lead frame plane and the second LED is placed on the first lead frame plane, wherein the LEDs are directly electrically connected to the first lead frame plane and electrically connected to the second lead frame plane by a wire bond each. Therein, the first LED on the first lead frame plane is connected to the second lead frame plane by a wire bond. Similar, the second LED on the first lead frame plane is connected to the second lead frame plane by a wire bond. Further, the first LED on the first lead frame plane may be electrically connected to the first lead frame plane by a wire bond or may be connected by an electrically conductive glue or soldering to the first lead frame plane. Similar, the second LED on the first lead frame plane may be electrically connected to the first lead frame plane by a wire bond or may be connected by an electrically conductive glue or soldering to the first lead frame plane. Therein, the lateral layers of the LEDs may be arranged anti-parallel. Thus, crossing of the conductors may be prevented by the specific arrangement of the LEDs on the lead frame.

Preferably, when the electrical connections on the lead frame are made by wire bonds only, the LED is nevertheless connected to the lead frame by an electrically conductive glue or soldering, to ease thermal conductance of the heat generated by the LED to the lead frame.

Preferably, the anode and the cathode of the first LED and the anode and the cathode of the second LED are connected to respective electrical contact pads on the lower side of the substrate and/or the upper side of the substrate. Therein, the electrical contact pads serve to electrically contact the LEDs from the outside. Internal connections within the substrate can be made by soldering, conductive gluing, wire or ribbon bonding, Copper lines, filled vias or the like. The present invention is neither limited to the specific type of connection from the outside, i.e. contacts to the electrical contact pads, nor to the specific type of internal connection between the LEDs and the electrical contact pads.

Preferably, the electrical contact pads are arranged in a 2x2 array. Consequently, the electrical contact pad connected to the anode of the first LED is directly next to the electrical contact pad connected to the cathode of the second LED, wherein the electrical contact pad connected to the cathode of the first LED is directly next to the electrical contact pad connected to the anode of the second LED. Hence, the electrical contact pads connected to the anode of the first LED and the cathode of the second LED as well as the electrical contact pads connected to the cathode of the first LED and the anode of the second LED can be easily connected without crossing conductors. Hence, neither internally within the substrate nor at the electrical contact pads crossing of conductors are necessary in order to be able to use the two LEDs in an antiparallel drive mode to be individually addressable.

Alternatively, the cathode of the first LED is connected to the anode of the second LED by a first electrical contact pad and the anode of the first LED is connected to the cathode of the second LED by a second electrical contact pad. In particular the electrical contact pads are arranged in a 1x2 array. Hence, antiparallel drive mode is already implemented by connection of the respective electrical contact pads. The cathode of the first LED and the anode of the second LED share a common electrical contact pad and similar, the anode of the first LED and the cathode of the second LED share a common electrical contact pad. Connection of the two LEDs is simplified and in particular no additional connectors, wires or electrical elements are necessary to use the two LEDs in the antiparallel drive mode.

Preferably, thermal contact pads are arranged in particular directly next to the electrical contact pads. Therein, the thermal contact pads have no electrical function and only serve as thermal contact to dissipate heat away from the dual color LED assembly. In particular, the thermal contact pads are arranged on the upper side of the substrate. However, more preferably, the thermal contact pads are arranged on the lower side of the substrate and being in direct contact for example with a cooling element to dissipate heat such as a heat sink or a heat pipe.

Preferably, the substrate carries only the two LEDs as electronic elements. No further electronic elements are present at the substrate. Alternatively, the substrate carries only the two LEDs and two TVS diodes as protection against ESD events. Thus, the substrate is less complex. In particular, the substrate is built to package the two LEDs to one LED assembly and has the sole function of having an LED assembly and providing connectivity to the LEDs (and maybe ESD protection of the LEDs). Thus, the substrate can be compact in size and consequently also the lighting device implementing the dual color LED assemblies can be compact.

Preferably the width of the substrate corresponds to 100 % to 150 % and preferably 110 % to 130 % of the combined width of the two LEDs. Thus, a compact and small dual color LED assembly can be provided and in particular the substrate is small enough in order to be implemented in a flexible lighting device. Therein, the combined width of the LEDs is the sum of the width of the first LED and the width of the second LED. In particular, the width of the substrate corresponds to a dimension in which the two LEDs are arranged next to each other.

Preferably, the substrate has an area of between 1mm² and 50mm² and preferably between 3mm² and 20mm². Thus, the substrate can be built compact and small and thus can be implemented in a compact lighting device.

Preferably, the conductor lines on or in the substrate are not crossed. Due to the specific arrangement of the first LED and the second LED on the substrate, it is not necessary to have a complex routing of the conductor lines on or in the substrate or by the wires connecting the dual color LED assembly. Instead, due to the specific arrangement of the LEDs, the conductor lines on the substrate need not to be crossed in order to be able to use the two LEDs in an antiparallel drive mode.

Preferably, the color of the first LED is white, and the color of the second LED is amber.

Alternatively, the colors of the first LED and the second LED can be selected from the colors blue, white, cyan, yellow, amber and red. In particular, the colors are selected according to the application of the dual color LED assembly.

Preferably, the first LED and/or the second LED generate light of a first wavelength. In particular, the first wavelength of the first LED and the second LED may be identically. Further, the first LED and/or the second LED may comprise a phosphor converting the light of the first wavelength into a second wavelength corresponding to the color of the first LED or second LED. Therein, as described before, the second wavelength of the first LED is different to the second wavelength of the second LED such that the first LED and the second LED have a different color.

In an aspect of the present invention a lighting device is provided comprising one or more dual color LED assemblies as described before, wherein the lighting device is implementing an antiparallel dual drive mode such that different LEDs on each of the dual color LED assemblies can be addressed by opposite voltages. Hence, the LEDs on each of the dual color LEDs assemblies as described before are connected in an antiparallel manner. This means that when one LED is powered the other LED is reversely biased to block the electrical current going through it. In consequence, at no point in time the two LEDs can be jointly powered in a way that both LEDs generate light simultaneously. Due to phosphor afterglow, this may be different for the light emitted from the LEDs, at least for short time periods.

Preferably, the lighting device does not comprise crossed conductor lines.

Preferably, the lighting device is an automotive lighting device.

In the following the present invention is described in more detail with reference to the accompanying figures.

The figures show:
- Figure 1: a perspective view of a dual color LED assembly according to the present invention,
- Figure 2: a side view of the dual color LED assembly of figure 1,
- Figure 3A: a view of the lower side of the dual color LED assembly according to Figure 1,
- Figure 3B: an alternative embodiment shown from the lower side,
- Figure 4: a schematic representation of the dual color LED assembly according to the present invention
- Figure 5A: another embodiment of a dual color LED assembly according to the present invention,
- Figure 5B: another embodiment of a dual color LED assembly according to the present invention, and
- Figure 6: another embodiment of a dual color LED assembly according to the present invention.

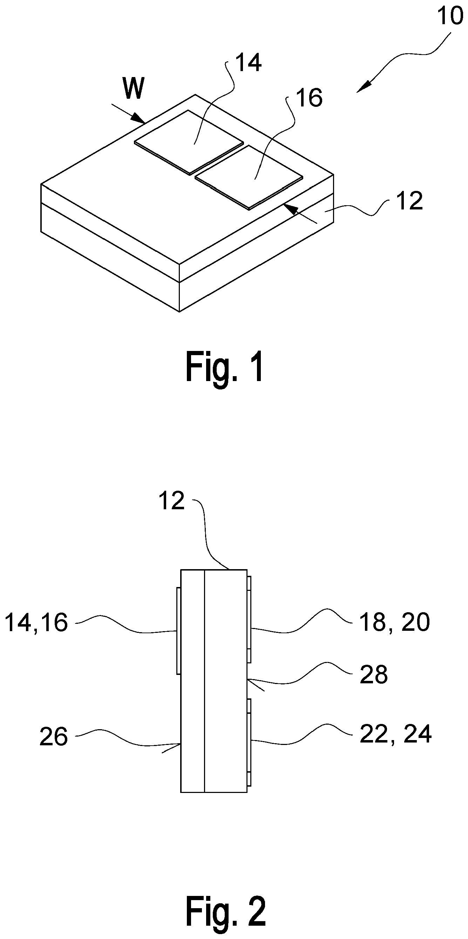

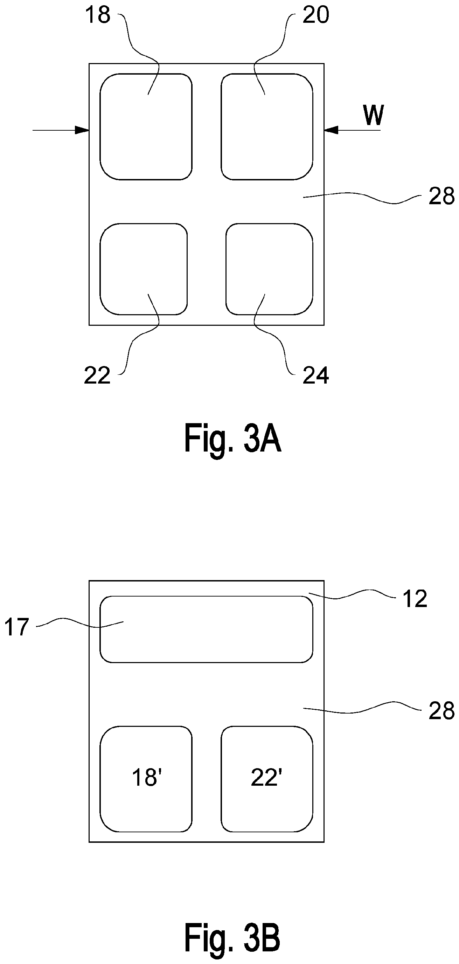

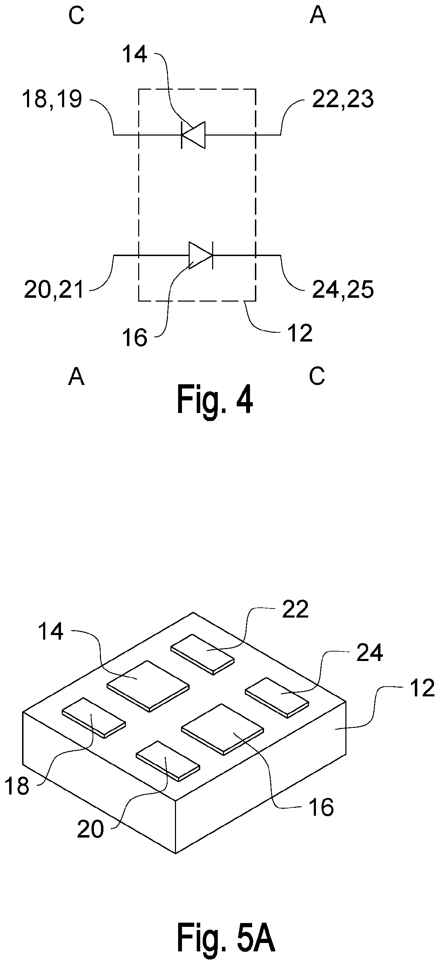

The dual color LED assembly 10 according to the present invention comprises a substrate 12 which is also called an interposer. The substrate 12 comprises an upper surface 26 as shown in Figure 2 and a lower surface 28 as shown in Figure 3. On the upper surface 26 a first LED 14 as well as a second LED 16 is arranged. Therein, the first LED 14 and the second LED 16 emit light with different colors. Further, the first LED 14 and the second LED 16 are arranged antiparallel on the substrate 12 as schematically depicted in Figure 4. Thus, in particular the anode 23 of the first LED 14 is arranged in the direction of the cathode 25 of the second LED 16. Preferably, the anode 23 of the first LED 14 is arranged directly next to the cathode 25 of the second LED 16. Similar, the cathode 19 of the first LED 14 is arranged in the same direction as the anode 21 of the second LED 16. In particular, the cathode 19 of the first LED 14 is arranged directly next to the anode 21 of the second LED 16.

As indicated in Figure 3A, on the lower side 28 of the substrate 12, electrical contact pads are arranged. Therein the cathode 19 of the first LED 14 is connected to a first electrical contact pad 18, wherein the anode 23 of the first LED 14 is connected to a second electrical contact pad 22. Similar, the anode 21 of the second LED 16 is connected to a third electrical contact pad 20, wherein the cathode 25 of the second LED 16 is connected to a fourth electrical contact pad 24. Consequently, the electrical contact pads 18, 20, 22, 24 are arranged in an 2x2 array, wherein the first electrical contact pad 18 is directly next to the third electrical contact pad 20 such that the cathode 19 of the first LED 14 is directly next to the anode 21 of the second LED 16. Similar, the second electrical contact pad 22 is directly next to the fourth electrical contact pad 24 such that the anode 23 of the first LED 14 is directly next to the cathode 25 of the second LED 16. Hence, LEDs 14, 16 can be used in an antiparallel drive mode easily without complex routing either from outside or within the substrate due to the antiparallel arraignment of the LEDs on the substrate.

In an alternative arrangement, the dual LED assembly comprises only two electrical contact pads in a 1x2 array as shown in Figure 3B. Therein, the cathode 19 of the first LED 14 is contacted by the electrical contact pad 18' to the anode 21 of the second LED 16. Similar, the anode 23 of the first LED 14 is contacted to the cathode 25 of the second LED 16 by the second electrical contact pad 22'. Thus, only two electrical contact pads are present which allow the dual LED assembly to be operated in antiparallel drive mode. In addition a thermal contact pad 17 may be present in order to enhance thermal dissipation.

Referring to Figure 4 showing schematically the arrangement of the first LED 14 and the second LED 16 together with the respective electrical contact pads 18, 20, 22, 24. Therein, in Figure 4 the physical arrangement of the LEDs on the substrate 12 are shown.

As described before, the substrate 12 is small in size and may have a width W of only 100 % to 150 % and preferably 100 % to 110 % of the combined width of the two LEDs. The width W is indicated in Figure 1 and is a dimension in which the two LEDs are arranged next to each other. Therein, the LEDs may be the only electrical components at the substrate 12 and serve only as carrier of the two LEDs providing connectivity of the two LEDs. Hence, the size of the substrate 12 may be small and is preferably between 5mm² and 50mm² and preferably between 7mm² and 20mm².

Referring to Figure 5A showing another embodiment. Same or similar elements are denoted with the same reference numbers. Therein, the electrical contact pads 18, 20, 22, 24 are arranged on the upper side of the substrate 12. Therein, the electrical contact pads 18, 20, 22, 24 can be connected for example by wire bonds.

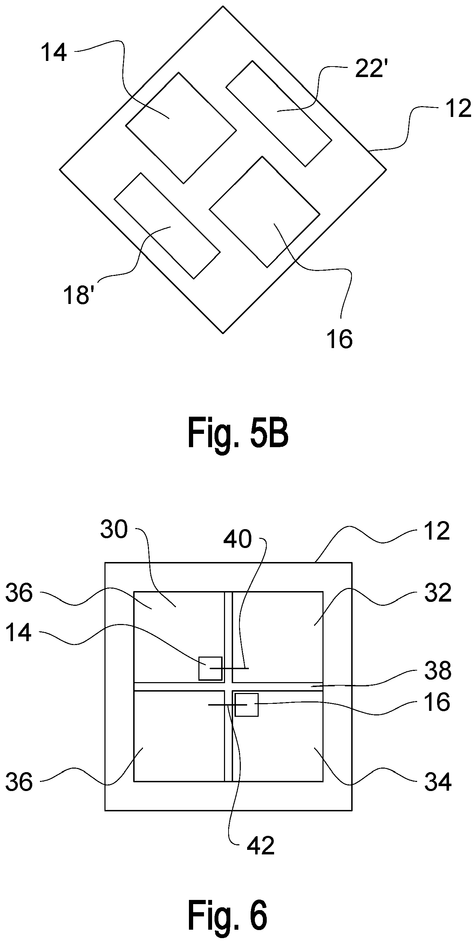

Referring to Figure 5B wherein the dual LED assembly comprises only two electrical contact pads similar to the embodiment of Figure 3B. Therein, the cathode 19 of the first LED 14 is contacted by the electrical contact pad 18' to the anode 21 of the second LED 16. Similar, the anode 23 of the first LED 14 is contacted to the cathode 25 of the second LED 16 by the second electrical contact pad 22'. Thus, only two electrical contact pads are present at the upper side which allow the dual LED assembly to be operated in antiparallel drive mode.

Referring to Figure 6 showing an embodiment having a lead frame split into four lead frame planes 30, 32, 34, 36 separated by gaps and arranged in a rectangle. Therein the first LED 14 is arranged on a first lead frame plane 30 and connected by a wire bond 40 to a neighboring second lead frame plane 32. The second LED 16 is arranged on the diagonally opposite third lead frame plane 34 and connected by a wire bond 42 to a neighboring fourth lead frame plane 36. Therein, the first LED 14 and the second LED 16 may be lateral LEDS. The LEDs 14, 16 and in particular their dies are arranged by lateral layers of the die arranged in the direction of light emission, i.e. along a direction perpendicular to the upper surface and/or the lower surface. The lateral layers define the anode and the cathode of the LEDs 14, 16. Therein, the layers of the two LEDs 14, 16 may be arranged in the same order, i.e. arranged in parallel. In other words, for both LEDs 14, 16 either the cathode or the anode may be directly connected to the respective lead frame plane, wherein the other is connected by the wire bond 40, 42 to the neighboring lead frame plane. Thus, by the diagonal arrangement of the LEDs on the lead frame planes, antiparallel drive mode becomes feasible without complex routing of electrical contacts for the two LEDs.

## Claims

1. Dual Color LED assembly comprising:
a substrate, having an upper side and an opposite lower side;
two LEDs arranged on the upper side of the substrate, wherein the LEDs are configured to emit light with different colors;
wherein the two LEDs are electrically connectable antiparallel on the substrate.

2. Dual Color LED assembly according to claim 1, wherein the two LEDs are arranged antiparallel on the substrate.

3. Dual Color LED assembly according to claim 1 or 2, wherein the anode of the first LED is directly next to the cathode of the second LED and the cathode of the first LED is directly next to the anode of the second LED.

4. Dual Color LED assembly according to any of claims 1 to 3 wherein the substrate is a ceramic or a rigid or flexible printed circuit board, PCB.

5. Dual Color LED assembly according to any of claims 1 to 3, wherein the substrate is a lead frame.

6. Dual Color LED assembly according to claim 5, wherein the two LEDs are embedded in a Silicone matrix and separated by a dam made of Silicone or Epoxy Molding Compound, to emit light of different color from two light emitting surfaces.

7. Dual Color LED assembly according to claim 5, wherein the two LEDs are embedded in a Silicone matrix to emit light from a common light emitting surface.

8. Dual color LED assembly according to any of claims 5 to 7, wherein the lead frame is split into four planes, the planes are arranged in a rectangle , separated from each other by gaps in the lead frame, **characterized in that** the LEDs are directly connected electrically conductive to diagonally opposite planes of the lead frame, and connected to one of the remaining planes each by wire bonds.

9. Dual color LED assembly according to any of claims 5 to 7, wherein the lead frame is split into four planes, the planes are arranged in a rectangle and separated from each other by gaps in the lead frame, **characterized in that** the LEDs are attached to diagonally opposite planes of the lead frame, wherein each LED is electrically connected to said opposite plane and to one of the remaining planes with a wire bond in a way that each quarter is contacting one LED by one wire bond.

10. Dual Color LED assembly according to any of claims 5 to 7, wherein the lead frame is separated into a first lead frame plane and a second lead frame plane separated by a gap in the lead frame, whereby one LED is placed on the first lead frame plane and the second LED is placed on the second lead frame plane, wherein the LEDs are directly electrically connected to the respective lead frame plane by conductive glue or a wire bond and electrically connected to the other lead frame plane by a wire bond each.

11. Dual Color LED assembly according to any of claims 1 to 10 wherein the anode and cathode of the first LED and the anode and cathode of the second LED are connected to respective electrical contact pads on the upper side and/or lower side of the substrate.

12. Dual Color LED assembly according to claim 11, wherein the electrical contact pads are arranged in a 2x2 array.

13. Dual Color LED assembly according to claim 11, wherein the cathode of the first LED is connected to the anode of the second LED by a first electrical contact pad and the anode of the first LED is connected to the cathode of the second LED by a second electrical contact pad.

14. Dual Color LED assembly according to claim 13, wherein the electrical contact pads are arranged in an 1x2 array.

15. Dual Color LED assembly according to claim 12 or 14, wherein the electrical contact pads are arranged on the upper side distant from each other, with the two LEDs arranged in between.

16. Dual Color LED assembly according to claim 1 to 15, comprising thermal contact pads without electrical function.

17. Dual Color LED assembly according to any of claims 1 to 16, wherein the substrate carries only the two LEDs as electronic elements or the two LEDs and two TVS diodes.

18. Dual Color LED assembly according to any of claims 1 to 17, wherein the width of the substrate corresponds to 100% to 150% and preferably 110% to 135% of the combined width of the two LEDs.

19. Dual Color LED assembly according to any of claims 1 to 18, wherein the area of the substrate is between 1mm² and 50mm² and preferably between 3mm² and 20mm².

20. Lighting device comprising one or more dual color LED assemblies of any of claims 1 to 19, wherein the LEDs of each dual color LED assembly are connected antiparallel.
